# EUROPEAN PATENT SPECIFICATION

(11) **EP 3 968 510 B1**
(45) Date of publication and mention of the grant of the patent: **19.02.2025**
(21) Application number: 20806402.2
(22) Date of filing: 20.02.2020
(51) Int. Cl.: G01R 31/34, H02M 7/48, H02P 29/024, H02M 7/5387

(54) **ELECTRIC POWER CONVERSION DEVICE, SYSTEM USING SAME, AND DIAGNOSTIC METHOD FOR SAME**
ELEKTRISCHE LEISTUNGSWANDLERVORRICHTUNG, SYSTEM DAMIT UND DIAGNOSEVERFAHREN DAFÜR
DISPOSITIF DE CONVERSION DE PUISSANCE ÉLECTRIQUE, SYSTÈME L'UTILISANT, ET SON PROCÉDÉ DE DIAGNOSTIC

(30) Priority: 10.05.2019 JP 2019089902
(43) Date of publication of application: 16.03.2022
(73) Proprietor: HITACHI INDUSTRIAL EQUIPMENT SYSTEMS CO., LTD., Tokyo 101-0022 (JP)
(72) Inventor: MAKI, Kohji, Tokyo 100-8280 (JP)
(74) Representative: MERH-IP Matias Erny Reichl Hoffmann Patentanwälte PartG mbB
(86) International application number: PCT/JP2020/006867
(87) International publication number: WO 2020/230399

(56) References cited:
- WO-A1-2019/017222
- JP-A- 2006 158 065
- JP-A- 2009 142 112
- JP-A- 2017 069 996
- JP-A- 2019 020 278
- US-B2- 8 547 714

## Description

### TECHNICAL FIELD

The present invention relates to an electric power conversion device connected to a transformer or a rotational machine such as a motor or a generator to feed and receive electric power thereto and therefrom, a system using the same, and a diagnostic method for the same.

### BACKGROUND ART

When a rotational machine such as a motor or a generator stops due to a sudden failure, great damage occurs. In particular, a stoppage due to a sudden failure of a motor used in factory equipment has a large impact, such as a decrease in an operating rate of production equipment and a need to revise a production plan. Therefore, there is an increasing need to prevent sudden failures of a motor by performing high-precision failure predictive diagnosis while using the motor in an actual environment.

Meanwhile, with the spread of renewable energy such as solar power generation and wind power generation, the number of transformers located downstream (output side) of an electric power conversion device is increasing. Since a voltage pulse generated by the electric power conversion device is applied to such a transformer at all times, there is a concern about acceleration of insulation deterioration, and insulation diagnosis during operation is desired.

In response to such a need, Patent Document 1 discloses a technology for applying a stepped voltage to a motor from an electric power conversion device, sampling a current at high speed to extract a peak value or a frequency of ringing, and detecting deterioration of coil insulation.
Patent Document 2 discloses a diagnosis device for diagnosing the state of a rotary machine system, a power conversion device, the rotary machine system.
Patent Document 3 discloses an output inverter for single phase which can detect a current with high precision through a smaller number of components, and an output current detecting method.

### CITATION LIST

### PATENT DOCUMENT

Patent Document 1: US 2014/0,176,152 A
Patent Document 2: WO 2019/017222 A1
Patent Document 3: US 8 547 714 B2

### SUMMARY OF THE INVENTION

### PROBLEMS TO BE SOLVED BY THE INVENTION

Patent Document 1 discloses a technology for applying a stepped voltage to a motor from an electric power conversion device, sampling a current at high speed to extract a peak value or a frequency of ringing, and detecting deterioration of coil insulation. However, this technology has a problem that a measuring device becomes expensive since sampling is performed at high speed as a ringing waveform can be directly measured.

The invention has been made to solve the problem of the conventional technology described above, and an object of the invention is to provide an electric power conversion device having a function of detecting a sign of an insulation failure of a rotational machine or a transformer at a low cost and at an early stage.

### SOLUTIONS TO PROBLEMS

An example of an "electric power conversion device" of the invention for solving the above problems is an electric power conversion device including an inverter circuit, and a PWM signal generation unit that compares a carrier signal with a voltage command value and generates a PWM signal for driving the inverter circuit, the electric power conversion device being connected to a rotational machine or a transformer including a winding wire to feed and receive electric power, the electric power conversion device including a current sensor that detects a current fed to and received from the rotational machine or the transformer, and a diagnostic unit that diagnoses insulation deterioration of the winding wire of the rotational machine or the transformer, in which the diagnostic unit includes a current sampling unit that obtains a current detection value by detecting a current of the current sensor at a timing of a peak or a valley of the carrier signal or both the peak and the valley, an extraction unit that extracts the current detection value at a detection timing of the current as a current detection value for insulation diagnosis when the detection timing is within a certain period of time from a timing when the voltage command value and the carrier signal intersect each other, an index value calculation unit that calculates an index value used for diagnosis from the extracted current detection value, and an insulation deterioration detection unit that detects insulation deterioration of the winding wire of the rotational machine or the transformer by a change from a normal state of the calculated index value.

In addition, an example of a "diagnostic method for a system using an electric power conversion device" of the invention is a diagnostic method for a system that includes an electric power conversion device including an inverter circuit, and a PWM signal generation unit that compares a carrier signal with a voltage command value and generates a PWM signal for driving the inverter circuit, and a rotational machine or a transformer having a winding wire connected to the electric power conversion device to feed and receive electric power, the method including a step of obtaining a current detection value by detecting a current from a current sensor that detects a current fed and received to and from the rotational machine or the transformer at a timing of a peak or a valley of the carrier signal or both the peak and the valley, a step of extracting the current detection value at a detection timing of the current as a current detection value for insulation diagnosis when the detection timing is within a certain period of time from a timing when the voltage command value and the carrier signal intersect each other, a step of calculating an index value used for diagnosis from the extracted current detection value, and a step of detecting insulation deterioration of the winding wire of the rotational machine or the transformer by a change from a normal state of the calculated index value.

### EFFECTS OF THE INVENTION

According to the invention, it is possible to provide an electric power conversion device having a function of detecting a sign of an insulation failure of a rotational machine or a transformer at a low cost and at an early stage.

A problem, a configuration, and an effect other than those described above will be clarified by a description of the following embodiments.

### BRIEF DESCRIPTION OF THE DRAWINGS

Fig. 1 is a basic configuration diagram of an electric power conversion device of a first embodiment of the invention and a system using the same.
Fig. 2 is a typical example of a voltage pulse train in pulse width modulation control.
Fig. 3 is a typical ringing current waveform generated in the electric power conversion device of the first embodiment.
Fig. 4 is a conceptual diagram of current sampling in the electric power conversion device of the first embodiment.
Fig. 5 is a schematic diagram of a carrier signal, a PWM pulse, and a phase current in the electric power conversion device of the first embodiment.
Fig. 6 is a flowchart for diagnosing insulation deterioration of a rotational machine or a transformer included in the electric power conversion device of the first embodiment.
Fig. 7 is a block configuration diagram illustrating details of a control/diagnostic unit of the first embodiment.
Fig. 8 is a basic configuration diagram of an electric power conversion device of a second embodiment of the invention and a system using the same.
Fig. 9 is a schematic diagram of a carrier signal, a PWM pulse, and a phase current in an electric power conversion device of a third embodiment of the invention.
Fig. 10 is a basic configuration diagram of an electric power conversion device of a fourth embodiment of the invention and a system using the same.
Fig. 11 is a schematic diagram of a pump, an air compressor, and a transfer table incorporating the electric power conversion device of the invention.
Fig. 12 is a schematic diagram of a solar power generation system incorporating the electric power conversion device of the invention.

### MODE FOR CARRYING OUT THE INVENTION

Hereinafter, embodiments of the invention will be described with reference to the drawings. Note that in each figure for demonstrating an embodiment, the same constituent element is given the same name and reference symbol as much as possible, and a repeated description thereof will be omitted.

### First embodiment

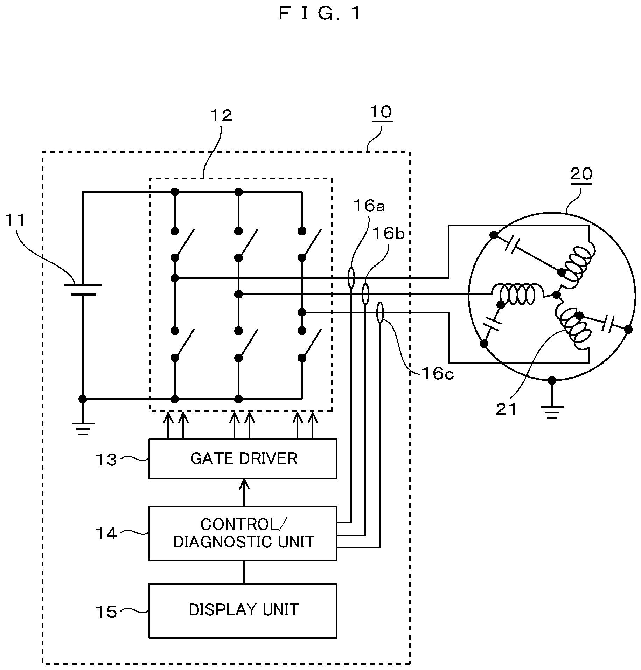

Fig. 1 is a basic configuration diagram of an electric power conversion device according to a first embodiment of the invention and a system using the same. This system includes an electric power conversion device 10 including a DC power supply 11, an inverter main circuit 12, a gate driver 13, a control/diagnostic unit 14, a display unit 15, and current sensors 16a, 16b, and 16c, and a rotational machine 20 connected to the electric power conversion device 10 to feed and receive electric power. The DC power supply 11 may be a rectified input from an AC power supply, or may be a storage battery or a capacitor. Further, the DC power supply 11 may be provided outside the electric power conversion device 10. As the armature coil 21 of the rotational machine, the case of Y-connection is illustrated in Fig. 1. However, Δ-connection may be used. Further, even though the case of a three-phase motor using three feeders is illustrated here, the number of phases may be different.

In the electric power conversion device 10, the gate driver 13 creates a drive signal based on a PWM pulse created by the control/diagnostic unit 14, and a switching device of the inverter main circuit 12 is switched to create a three-phase alternating current driving the rotational machine 20 from the DC power supply 11. Then, the creation of the PWM pulse is controlled based on the current detection signals detected by the current sensors 16a, 16b, and 16c, and as will be described later, the control/diagnostic unit 14 diagnoses a sign of insulation failure and displays the sign on the display unit 15.

When the insulating material of the armature coil 21 of the rotational machine 20 deteriorates, the capacitance changes before the insulation resistance decreases. For example, when the insulating material deteriorates due to heat, vibration, etc., voids are generated inside the material or peeling occurs on the material surface. Then, since the permeability of air is generally smaller than the permeability of the insulating material, a capacitance between the coil conductor and the iron core tends to decrease. On the other hand, when water enters the generated voids or peeled part, the permeability of water is generally larger than the permeability of the insulating material, so that the capacitance between the coil conductor and the iron core increases. Further, when the water disappears, the capacitance decreases again. As the deterioration progresses and the number of voids and peeling increases, the increase or decrease in capacitance with the amount of water increases. In the invention, by detecting such a change in capacitance, insulation deterioration is detected at an early stage and used as a failure sign.

The change in capacitance is detected in the form of a change in ringing current waveform. A peak value or a frequency of the ringing current waveform changes as the capacitance changes. Thus, when the change can be apprehended, the change in capacitance can be detected.

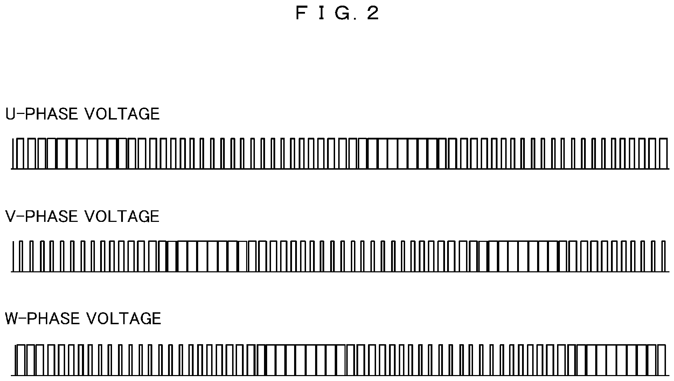

In the invention, the current measurement by the current sensor is performed while the electric power conversion device is applying a pulse width-modulated voltage pulse to the rotational machine or the transformer. Fig. 2 illustrates a typical example (three-phase voltage) of the voltage pulse train.

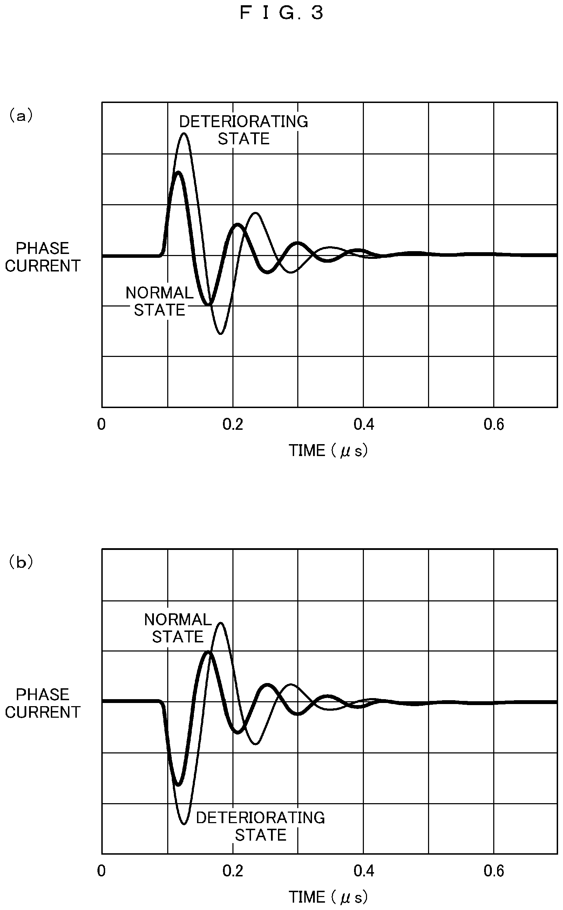

Next, Fig. 3 illustrates a typical current waveform measured by a certain one-phase current sensor when a voltage pulse is applied. Fig. 3(a) is a current waveform at the rising timing of the voltage pulse, and Fig. 3(b) is a current waveform at the falling timing of the voltage pulse. Note that a value of the phase current at time zero may not be zero. Each figure overlaps and illustrates the case of a normal state (normal state) and the case in which the insulating material of the armature coil of the rotational machine deteriorates, and the capacitance to ground of the armature coil in a phase in which the current is measured doubles (deteriorating state). It can be seen that current ringing (vibration) occurs at the rising edge and the falling edge of the voltage pulse, and a peak value or a frequency thereof differ between the normal state and the deteriorating state. Therefore, when a plurality of points can be sampled and the entire ringing waveform can be apprehended to some extent, a deterioration sign can be detected.

This ringing frequency is typically about 10 MHz, and in order to accurately measure a peak value or a frequency thereof and apprehend a deterioration sign at an early stage, high-speed sampling of 100 MHz or more has been required in a conventional technology. Therefore, a control microcomputer normally provided in the electric power conversion device cannot keep up with the speed, and it is necessary to additionally install an expensive measuring device.

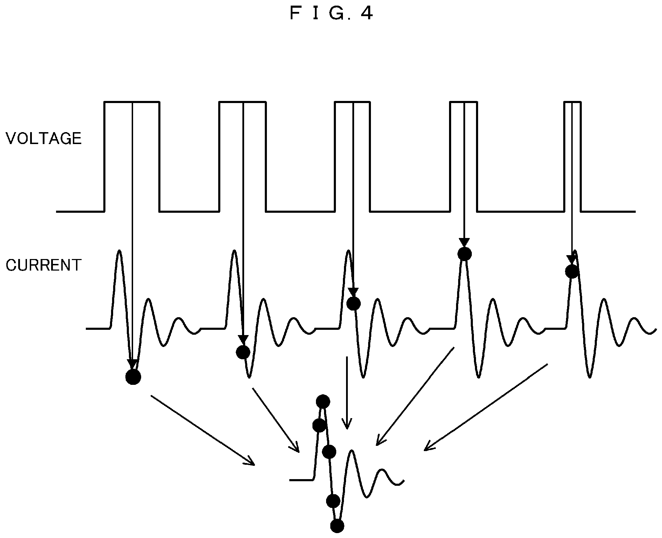

Therefore, as a conceptual diagram is illustrated in Fig. 4, the invention focuses on the ability to reconstruct the ringing current waveform when a current is sampled and synthesized at a timing of dividing a pulse width at a certain ratio, for example, at a timing of a pulse center in the case of 1 : 1 while gradually changing a voltage pulse width to be applied. That is, even when a timing of current measurement is fixed at the pulse center, it is possible to collect current values measured at timings such that delay times from the start of the rise and the fall of the pulse are different from each other by changing the pulse width. In the pulse width modulation control normally used when driving the motor in the electric power conversion device, the width of the applied voltage pulse changes from moment to moment as illustrated in Fig. 2, and thus the use is allowed without change. Further, as a current measurement method, a method of measuring at a timing of a peak or a valley of a carrier signal or both of the peak and the valley, which is normally used, can be imitated.

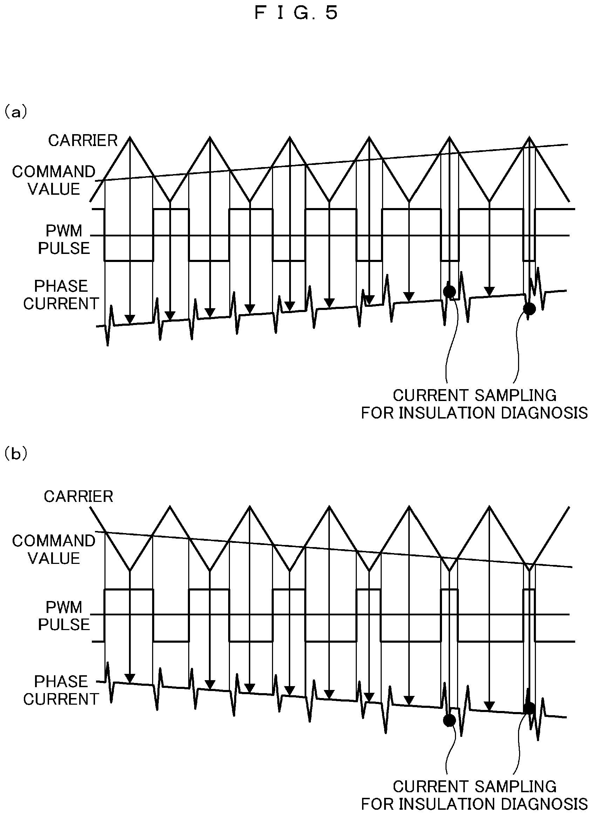

Fig. 5 illustrates a relationship between a carrier signal, a PWM pulse, and a phase current detected by the current sensor. By comparing a carrier signal including a triangular wave with a voltage command value (for example, a sine wave), a PWM pulse that rises and falls at a timing when the voltage command value and the carrier signal intersect each other is created. In addition, the phase current is sampled at a timing of a peak or a valley of the carrier signal. Then, as illustrated in the figure, selection as diagnostic data is performed only when the PWM pulse becomes thin (a duty ratio approaches 0% to 100%). That is, selection as the diagnostic data is performed when a current detection timing is within a certain period of time from the timing when the voltage command value and the carrier signal intersect each other. In this way, only a ringing waveform is naturally extracted on the extension of the current measurement for control. Note that in Fig. 5, Fig. 5(a) illustrates the case of extracting at the peak of the carrier, and Fig. 5(b) illustrates the case of extracting at the valley of the carrier.

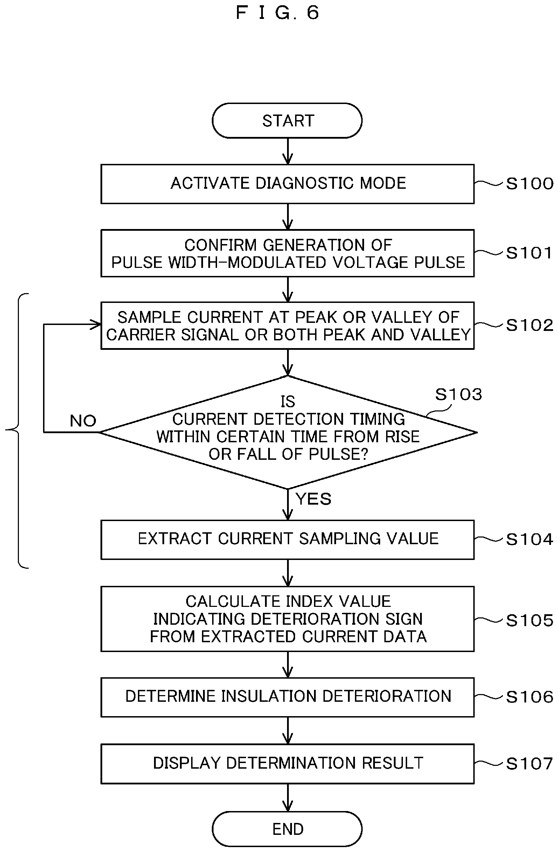

Fig. 6 illustrates a flowchart for diagnosing insulation deterioration of the rotational machine included in the electric power conversion device of the present embodiment. First, in step S100, a diagnostic mode is activated. A user interface for commanding a start of diagnosis is included. For example, in addition to a method of selecting the activation of the diagnostic mode from setting items of the electric power conversion device, it is possible to use a scheme of pressing a mechanical button for activating the diagnostic mode or a scheme of touching a "diagnosis mode" button displayed on a display. Alternatively, it is possible to perform setting to start automatically at a specific date and time, or to start automatically before or after a specific rotational machine control operation. Further, a condition for starting the diagnostic mode may be designated.

Subsequently, in step S101, generation of a pulse width-modulated voltage pulse is confirmed.

Subsequently, in step S102, the current is sampled at the peak or the valley of the carrier signal or at both the peak and the valley. Then, in step S103, it is determined whether a current detection timing is within a certain time from the rise or the fall of the pulse, and when the timing is within the certain time, a current sampling value is extracted in step S104. Note that steps S102 to S104 may be repeated a plurality of times.

Subsequently, in step S105, an index value indicating a deterioration sign is calculated from extracted current data. A fundamental frequency component of the phase current is not used for insulation diagnosis, and thus is removed using a low pass filter, etc. Thereafter, for example, a square value or an absolute value may be added up for a certain period of time to calculate a moving average, or a peak value of ringing may be extracted. Alternatively, a ringing cycle may be extracted.

Then, in step S106, it is whether or not the calculated index value exceeds or falls below a preset threshold value, or whether or not a degree of abnormality when the index value is analyzed by a machine learning algorithm such as vector quantization clustering exceeds a preset upper limit. When this determination criterion is satisfied, it is diagnosed that there is a deterioration sign. As the determination criterion, it is possible to use an index value calculated in advance during a learning period.

Finally, in step S107, a diagnosis result is displayed and the diagnosis is completed. A display method may be a display, a lamp, a buzzer, etc. using the five human senses, or may be recorded on paper or an electronic file. Alternatively, the diagnosis result may be transmitted to an external device via a communication network. Further, in addition to the diagnosis result, it is possible to display or transmit information on whether or not diagnosis can be carried out in the first place or diagnosis progress information. Further, along with the diagnosis result, it is possible to output a parameter that defines an operating state, for example, rotations per minute (RPM), torque, etc. In this way, it is possible to perform more precise diagnosis.

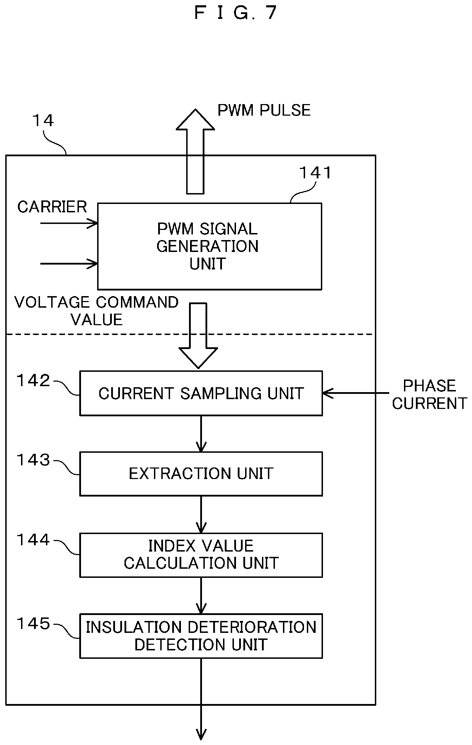

Fig. 7 illustrates a block configuration diagram of the control/diagnostic unit 14 of Fig. 1 implementing the flowchart of Fig. 6. As illustrated in Fig. 7, the control/diagnostic unit 14 includes a PWM signal generation unit 141 that compares a carrier signal with a voltage command value and creates a PWM pulse. In addition, as illustrated in Fig. 7, the control/diagnostic unit 14 includes a current sampling unit 142 that samples a phase current detected by the current sensor using a PWM pulse, an extraction unit 143 that extracts a current sampling value within a certain period of time from a rise/fall of a pulse, an index value calculation unit 144 that calculates an index value indicating a deterioration sign from extracted current data, and an insulation deterioration detection unit 145 that detects insulation deterioration. These processing units of the control/diagnostic unit 14 can be configured by software by incorporating a program into a computer.

According to the electric power conversion device of the present embodiment, since high-speed sampling is not required, diagnosis can be executed by the microcomputer and the current sensor mounted on the electric power conversion device. Further, since the capacitance of the insulating material is measured instead of the insulation resistance, deterioration of the insulating material can be detected with high sensitivity. Further, due to the common current measurement timing in the normal operation of the electric power conversion device, diagnostic data can be collected without difficulty during the normal operation. Furthermore, since only ringing current waveform data necessary for diagnosis is extracted, the load of post-processing calculation or communication of machine learning, etc. can be reduced. As described above, it is possible to realize the electric power conversion device having a function of detecting a sign of an insulation failure of the rotational machine at a low cost and an early stage, and the system using the same.

### Second embodiment

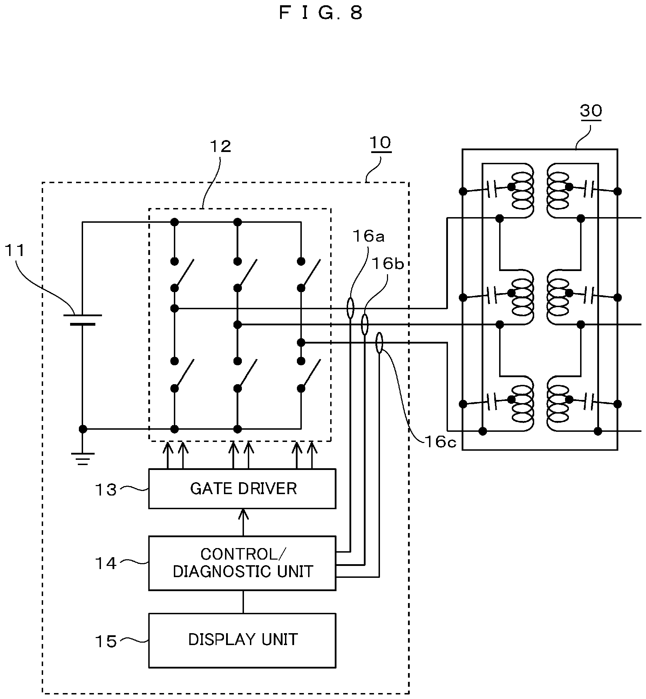

Fig. 8 illustrates a basic configuration diagram of a system having an electric power conversion device according to a second embodiment of the invention. A difference from the first embodiment is that a transformer 30 is connected to an electric power conversion device 10 instead of the rotational machine. A configuration of an insulation/diagnostic unit 14 of the electric power conversion device 10 is the same as that of the first embodiment. Note that even though Fig. 8 illustrates the case of Δ-Δ connection, it is possible to adopt other connections, for example, Δ-Y connection and Y-Δ connection. Further, even though the case of a three-phase transformer using three feeders is illustrated here, the number of phases may be different.

By performing diagnosis on the system including the electric power conversion device and the transformer using a similar flowchart to that of Fig. 6 of the first embodiment, it is possible to detect a sign of an insulation failure of the transformer at low cost and at an early stage.

### Third embodiment

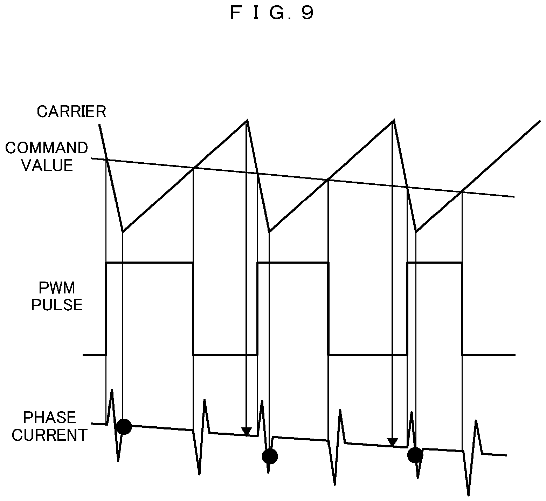

Fig. 9 is a schematic diagram of a carrier signal, a PWM pulse, and a phase current detected by a current sensor in a third embodiment of the invention. A difference from the first embodiment is that a triangular wave of the carrier signal is not symmetrical as illustrated in Fig. 5 and is asymmetrical in a front-back direction. That is, an asymmetric triangular wave in which a length of an increase period from a minimum value to a maximum value is different from a length of a decrease period from a maximum value to a minimum value is used as the carrier signal. A reason is that when a ringing attenuation time is excessively short with respect to a minimum pulse width, ringing does not continue to a pulse center, and a waveform cannot be apprehended by current sampling at the pulse center.

Therefore, in the present embodiment, the triangular wave of the carrier signal is made asymmetrical in the front-back direction, and a timing of current sampling is shifted from the pulse center. The figure illustrates an example in which a valley of the carrier signal is brought closer to a rising edge of the PWM pulse. In this way, it becomes possible to apprehend the ringing current waveform even when the ringing attenuation time is short, and it is possible to carry out an insulation diagnosis.

### Fourth embodiment

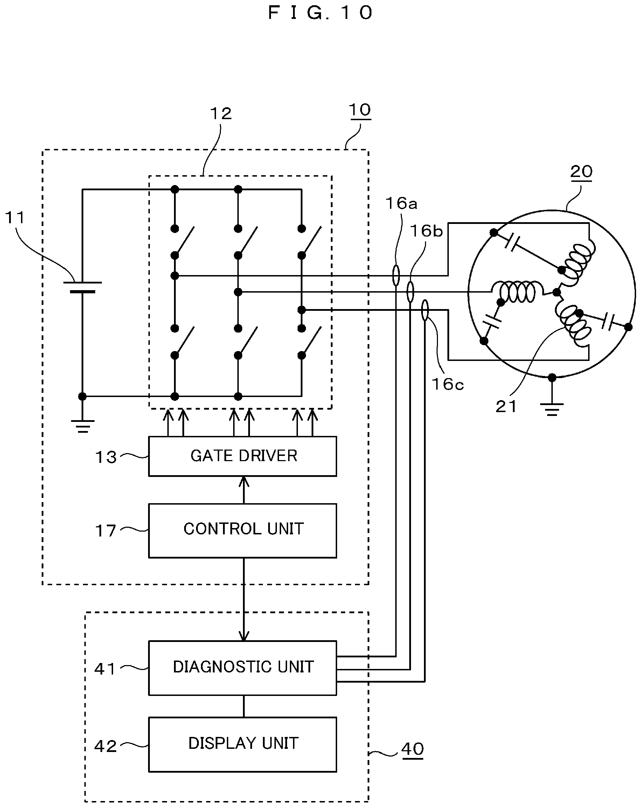

Fig. 10 is a basic configuration diagram of an electric power conversion device of a fourth embodiment of the invention and a system using the same. A difference from the first embodiment is that a diagnostic device 40 is externally attached in addition to the electric power conversion device 10 connected to the rotational machine or the transformer. A diagnostic unit 41 of the diagnostic device 40 obtains information on a pulse width and a pulse generation timing from the control unit 17 of the electric power conversion device 10, and performs current sampling for the phase current at an appropriate timing. A diagnosis result is displayed on a display unit 42.

According to the present embodiment, with such a configuration, it is possible to calculate an index value indicating a deterioration sign without being affected by the performance of a control microcomputer.

### Fifth embodiment

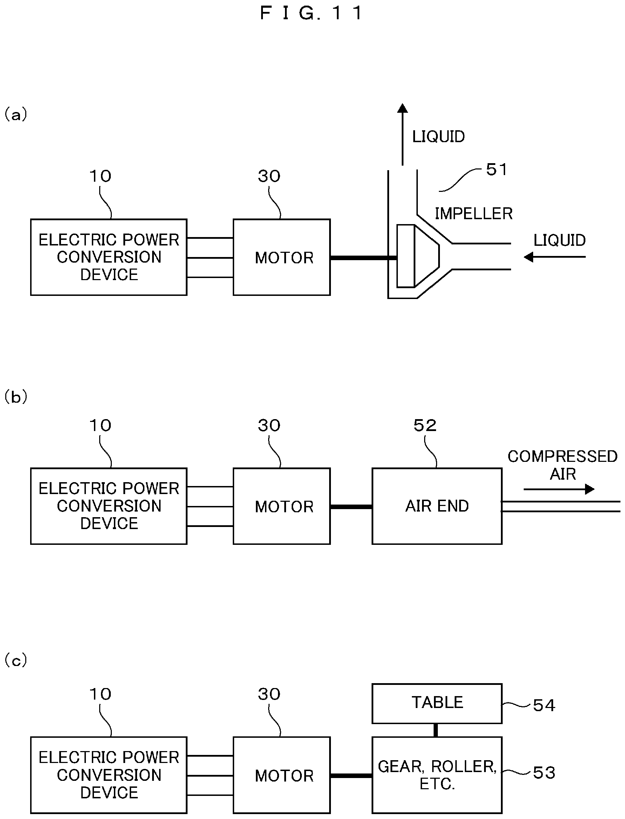

Fig. 11 illustrates a schematic diagram of products incorporating the electric power conversion device of the invention.

Fig. 11(a) is a schematic diagram of a pump incorporating the electric power conversion device according to the invention. An impeller of a pump 51 is connected to a motor 30 connected to an electric power conversion device 10 to suck and send out a liquid such as water.

In addition, Fig. 11(b) is a schematic diagram of an air compressor incorporating the electric power conversion device according to the invention. An air end 52 that compresses air is coupled to a motor 30 connected to the electric power conversion device 10 to deliver compressed air.

In addition, Fig. 11(c) is a schematic diagram of a transfer table incorporating the electric power conversion device according to the invention. A transfer table 54 is connected to the motor 30 connected to the electric power conversion device 10 via a gear, a roller, etc. 53.

As described above, by incorporating the electric power conversion device according to the invention into various industrial devices, it is possible to reduce the sudden failure of the motor incorporated therein.

### Sixth embodiment

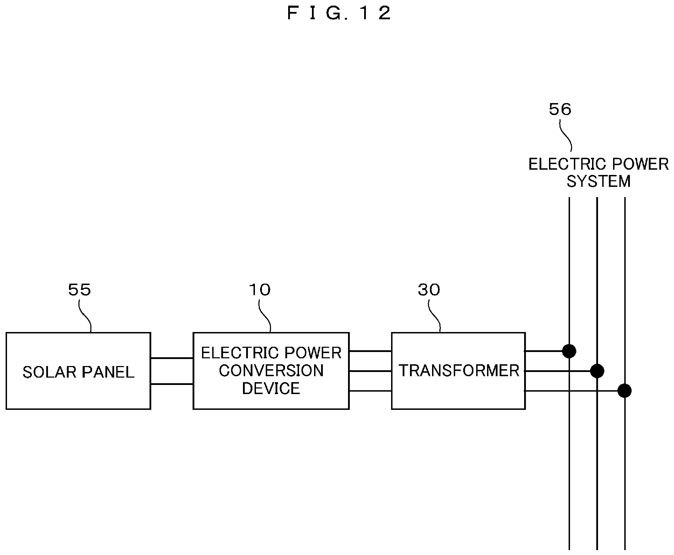

Fig. 12 illustrates a schematic diagram of a solar power generation system incorporating the electric power conversion device according to the invention. A DC voltage from a solar panel 55 is converted into an alternating current by the electric power conversion device 10, and the converted alternating current is boosted by a transformer 30 and connected to an electric power system 56.

According to the present embodiment, it is possible to diagnose the insulation deterioration of the transformer connected to the downstream side (output side) of the electric power conversion device. Note that the invention can be applied to a power storage system in which a solar panel part is replaced with a storage battery.

Even though the embodiments have been described above, the invention is not limited to the above-mentioned embodiments, and various modifications are included. For example, the embodiments have been described in detail to describe the invention in an easy-to-understand manner, and are not necessarily limited to those having all the described configurations.

### REFERENCE SIGNS LIST

- 10: Electric power conversion device
- 11: DC power supply
- 12: Inverter main circuit
- 13: Gate driver
- 14: Control/diagnostic unit
- 15: Display unit
- 16: Current sensor
- 17: Control unit
- 20: Rotational machine
- 21: Armature coil
- 30: Transformer
- 40: Diagnostic device
- 41: Diagnostic unit
- 42: Display unit
- 51: Pump
- 52: Air end
- 53: Gear, roller, etc.
- 54: Table
- 55: Solar panel
- 56: Electric power system
- 141: PWM signal generation unit
- 142: Current sampling unit
- 143: Extraction unit
- 144: Index value calculation unit
- 145: Insulation deterioration detection unit

## Claims

1. An electric power conversion device including an inverter circuit, and a PWM signal generation unit (141) that compares a carrier signal with a voltage command value and generates a PWM signal for driving the inverter circuit, the electric power conversion device being connected to a rotational machine (20) or being connected to a transformer (30) which include a winding wire to feed and receive electric power, the electric power conversion device comprising:
a current sensor (16) that detects a current fed to and received from the rotational machine (20) or the transformer (30); and
a diagnostic unit (41) that diagnoses insulation deterioration of the winding wire of the rotational machine (20) or the transformer (30),
wherein the diagnostic unit (41) includes
a current sampling unit (142) that obtains a current detection value by detecting a current of the current sensor (16) at a detection timing which is a timing of a peak or a valley of the carrier signal or both the peak and the valley,
an extraction unit (143) that extracts the current detection value at the detection timing of the current as a current detection value for insulation diagnosis when the detection timing is within a certain period of time from a timing when the voltage command value and the carrier signal intersect each other,
an index value calculation unit (144) that calculates an index value used for diagnosis from the extracted current detection value, and
an insulation deterioration detection unit (145) that detects insulation deterioration of the winding wire of the rotational machine (20) or the transformer (30) by a change from a normal state of the calculated index value.

2. The electric power conversion device according to claim 1, wherein the insulation deterioration detection unit (145) detects a change in capacitance of the winding wire.

3. The electric power conversion device according to claim 1, wherein the index value calculation unit (144) removes a low frequency component from the current detection value, and then sets a value obtained by adding up an absolute value or a square value for a certain period of time as the index value.

4. The electric power conversion device according to claim 1, wherein the electric power conversion device has a function of determining a determination criterion whether or not the calculated index value exceeds or falls below a preset threshold value for detecting insulation deterioration using the index value calculated during a learning period.

5. The electric power conversion device according to claim 1, wherein the electric power conversion device has a function of designating a condition for starting calculation of the index value.

6. The electric power conversion device according to claim 1, wherein the electric power conversion device has a function of outputting the calculated index value together with a parameter that defines an operating state.

7. The electric power conversion device according to claim 1, wherein the carrier signal is a triangular wave.

8. The electric power conversion device according to claim 1, wherein the carrier signal is an asymmetric triangular wave in which a length of an increase period from a minimum value to a maximum value is different from a length of a decrease period from a maximum value to a minimum value.

9. The electric power conversion device according to claim 1, further comprising
a user interface for commanding a start of diagnosis.

10. The electric power conversion device according to claim 1, further comprising
an interface for displaying diagnosis availability, a diagnosis progress status, or a diagnosis result or communicating with an outside.

11. The electric power conversion device according to claim 1, wherein the electric power conversion device feeds and receives three-phase electric power.

12. The electric power conversion device according to claim 1, wherein the diagnostic unit (41) is externally attached to the electric power conversion device.

13. A system comprising:
the electric power conversion device according to any one of claims 1 to 12; and
a rotational machine (20) or a transformer (30) connected to the electric power conversion device to feed and receive electric power.

14. A diagnostic method for a system that includes an electric power conversion device including an inverter circuit, and a PWM signal generation unit (141) that compares a carrier signal with a voltage command value and generates a PWM signal for driving the inverter circuit, and a rotational machine (20) or a transformer (30) having a winding wire connected to the electric power conversion device to feed and receive electric power, the method comprising:
a step of obtaining a current detection value by detecting a current from a current sensor (16) that detects a current fed to and received from the rotational machine (20) or the transformer (30) at a detection timing which is a timing of a peak or a valley of the carrier signal or both the peak and the valley;
a step of extracting the current detection value at the detection timing of the current as a current detection value for insulation diagnosis when the detection timing is within a certain period of time from a timing when the voltage command value and the carrier signal intersect each other;
a step of calculating an index value used for diagnosis from the extracted current detection value; and
a step of detecting insulation deterioration of the winding wire of the rotational machine (20) or the transformer (30) by a change from a normal state of the calculated index value.

15. The diagnostic method according to claim 14, wherein the step of detecting the insulation deterioration includes detecting a change in capacitance of the winding wire.

## Patentansprüche

1. Elektrische Leistungsumwandlungsvorrichtung, die eine Wechselrichterschaltung und eine PWM-Signalerzeugungseinheit (141) enthält, die ein Trägersignal mit einem Spannungsbefehlswert vergleicht und ein PWM-Signal zum Ansteuern der Wechselrichterschaltung erzeugt, wobei die elektrische Leistungsumwandlungsvorrichtung mit einer Rotationsmaschine (20) verbunden ist oder mit einem Transformator (30) verbunden ist, der einen Wicklungsdraht enthält, um elektrische Leistung zuzuführen und zu empfangen, wobei die elektrische Leistungsumwandlungsvorrichtung Folgendes umfasst:
einen Stromsensor (16), der einen Strom erfasst, der der Rotationsmaschine (20) oder dem Transformator (30) zugeführt und von dieser empfangen wird; und
eine Diagnoseeinheit (41), die eine Isolationsverschlechterung des Wicklungsdrahts der Rotationsmaschine (20) oder des Transformators (30) diagnostiziert,
wobei die Diagnoseeinheit (41) Folgendes enthält:
eine Stromabtasteinheit (142), die einen Stromerfassungswert durch Erfassen eines Stroms des Stromsensors (16) zu einem Erfassungszeitpunkt erhält, der ein Zeitpunkt einer Spitze oder eines Tals des Trägersignals oder sowohl der Spitze als auch des Tals ist,
eine Extraktionseinheit (143), die den Stromerfassungswert zu dem Erfassungszeitpunkt des Stroms als einen Stromerfassungswert für eine Isolationsdiagnose extrahiert, wenn der Erfassungszeitpunkt innerhalb einer bestimmten Zeitperiode von einem Zeitpunkt ist, zu dem der Spannungsbefehlswert und das Trägersignal einander schneiden,
eine Indexwertberechnungseinheit (144), die einen Indexwert, der für eine Diagnose verwendet wird, aus dem extrahierten Stromerfassungswert berechnet, und
eine Isolationsverschlechterungserfassungseinheit (145), die eine Isolationsverschlechterung des Wicklungsdrahts der Rotationsmaschine (20) oder des Transformators (30) durch eine Änderung von einem Normalzustand des berechneten Indexwerts erfasst.

2. Elektrische Leistungsumwandlungsvorrichtung nach Anspruch 1, wobei die Isolationsverschlechterungserfassungseinheit (145) eine Änderung der Kapazität des Wicklungsdrahts erfasst.

3. Elektrische Leistungsumwandlungsvorrichtung nach Anspruch 1, wobei die Indexwertberechnungseinheit (144) eine Niederfrequenzkomponente aus dem Stromerfassungswert entfernt und dann einen Wert, der durch Aufaddieren eines Absolutwerts oder eines Quadratwerts für eine bestimmte Zeitperiode erhalten wird, als den Indexwert einstellt.

4. Elektrische Leistungsumwandlungsvorrichtung nach Anspruch 1, wobei die elektrische Leistungsumwandlungsvorrichtung eine Funktion des Bestimmens eines Bestimmungskriteriums, ob der berechnete Indexwert einen voreingestellten Schwellenwert überschreitet oder unterschreitet, oder nicht, zum Erfassen einer Isolationsverschlechterung unter Verwendung des Indexwerts, der während einer Lernperiode berechnet wird, aufweist.

5. Elektrische Leistungsumwandlungsvorrichtung nach Anspruch 1, wobei die elektrische Leistungsumwandlungsvorrichtung eine Funktion des Bestimmens einer Bedingung zum Starten der Berechnung des Indexwerts aufweist.

6. Elektrische Leistungsumwandlungsvorrichtung nach Anspruch 1, wobei die elektrische Leistungsumwandlungsvorrichtung eine Funktion des Ausgebens des berechneten Indexwerts zusammen mit einem Parameter, der einen Betriebszustand definiert, aufweist.

7. Elektrische Leistungsumwandlungsvorrichtung nach Anspruch 1, wobei das Trägersignal eine Dreieckswelle ist.

8. Elektrische Leistungsumwandlungsvorrichtung nach Anspruch 1, wobei das Trägersignal eine asymmetrische Dreieckswelle ist, bei der sich eine Länge einer Anstiegsperiode von einem Minimalwert zu einem Maximalwert von einer Länge einer Abfallperiode von einem Maximalwert zu einem Minimalwert unterscheidet.

9. Elektrische Leistungsumwandlungsvorrichtung nach Anspruch 1, ferner umfassend
eine Benutzerschnittstelle zum Befehlen eines Starts einer Diagnose.

10. Elektrische Leistungsumwandlungsvorrichtung nach Anspruch 1, ferner umfassend
eine Schnittstelle zum Anzeigen einer Diagnoseverfügbarkeit, eines Diagnosefortschrittsstatus oder eines Diagnoseergebnisses oder zum Kommunizieren mit einer Außenseite.

11. Elektrische Leistungsumwandlungsvorrichtung nach Anspruch 1, wobei die elektrische Leistungsumwandlungsvorrichtung dreiphasige elektrische Leistung zuführt und empfängt.

12. Elektrische Leistungsumwandlungsvorrichtung nach Anspruch 1, wobei die Diagnoseeinheit (41) extern an der elektrischen Leistungsumwandlungsvorrichtung angebracht ist.

13. System, umfassend:
die elektrische Leistungsumwandlungsvorrichtung nach einem der Ansprüche 1 bis 12; und
eine Rotationsmaschine (20) oder einen Transformator (30), die bzw. der mit der elektrischen Leistungsumwandlungsvorrichtung verbunden ist, um elektrische Leistung zuzuführen und zu empfangen.

14. Diagnoseverfahren für ein System, das eine elektrische Leistungsumwandlungsvorrichtung, die eine Wechselrichterschaltung und eine PWM-Signalerzeugungseinheit (141) enthält, die ein Trägersignal mit einem Spannungsbefehlswert vergleicht und ein PWM-Signal zum Ansteuern der Wechselrichterschaltung erzeugt, und eine Rotationsmaschine (20) oder einen Transformator (30) enthält, der bzw. der einen Wicklungsdraht aufweist, der bzw. der mit der elektrischen Leistungsumwandlungsvorrichtung verbunden ist, um elektrische Leistung zuzuführen und zu empfangen, wobei das Verfahren Folgendes umfasst:
einen Schritt des Erhaltens eines Stromerfassungswerts durch Erfassen eines Stroms von einem Stromsensor (16), der einen Strom erfasst, der der Rotationsmaschine (20) oder dem Transformator (30) zugeführt und von dieser empfangen wird, zu einem Erfassungszeitpunkt, der ein Zeitpunkt einer Spitze oder eines Tals des Trägersignals oder sowohl der Spitze als auch des Tals ist;
einen Schritt des Extrahierens des Stromerfassungswerts zu dem Erfassungszeitpunkt des Stroms als einen Stromerfassungswert für eine Isolationsdiagnose, wenn der Erfassungszeitpunkt innerhalb einer bestimmten Zeitperiode von einem Zeitpunkt ist, zu dem der Spannungsbefehlswert und das Trägersignal einander schneiden;
einen Schritt des Berechnens eines Indexwerts, der für eine Diagnose verwendet wird, aus dem extrahierten Stromerfassungswert; und
einen Schritt des Erfassens einer Isolationsverschlechterung des Wicklungsdrahts der Rotationsmaschine (20) oder des Transformators (30) durch eine Änderung von einem Normalzustand des berechneten Indexwerts.

15. Diagnoseverfahren nach Anspruch 14, wobei der Schritt des Erfassens der Isolationsverschlechterung das Erfassen einer Änderung der Kapazität des Wicklungsdrahts enthält.

## Revendications

1. Dispositif de conversion de puissance électrique incluant un circuit inverseur, et une unité de génération de signal PWM (141) qui compare un signal de porteuse avec une valeur de commande de tension et génère un signal PWM pour commander le circuit inverseur, le dispositif de conversion de puissance électrique étant connecté à une machine rotative (20) ou étant connecté à un transformateur (30) qui inclut un fil d'enroulement pour alimenter et recevoir une puissance électrique, le dispositif de conversion de puissance électrique comprenant :
un capteur de courant (16) qui détecte un courant alimenté à et reçu de la machine rotative (20) ou du transformateur (30) ; et
une unité de diagnostic (41) qui diagnostique une détérioration d'isolation du fil d'enroulement de la machine rotative (20) ou du transformateur (30),
dans lequel l'unité de diagnostic (41) inclut
une unité d'échantillonnage de courant (142) qui obtient une valeur de détection de courant en détectant un courant du capteur de courant (16) à un moment de détection qui est un moment d'un pic ou d'un creux du signal de porteuse ou à la fois du pic et du creux,
une unité d'extraction (143) qui extrait la valeur de détection de courant au moment de détection du courant en tant que valeur de détection de courant pour un diagnostic d'isolation lorsque le moment de détection est dans une certaine période de temps à partir d'un moment où la valeur de commande de tension et le signal de porteuse se croisent,
une unité de calcul de valeur d'indice (144) qui calcule une valeur d'indice utilisée pour un diagnostic à partir de la valeur de détection de courant extraite, et
une unité de détection de détérioration d'isolation (145) qui détecte une détérioration d'isolation du fil d'enroulement de la machine rotative (20) ou du transformateur (30) par un changement à partir d'un état normal de la valeur d'indice calculée.

2. Dispositif de conversion de puissance électrique selon la revendication 1, dans lequel l'unité de détection de détérioration d'isolation (145) détecte un changement de capacité du fil d'enroulement.

3. Dispositif de conversion de puissance électrique selon la revendication 1, dans lequel l'unité de calcul de valeur d'indice (144) supprime une composante basse fréquence de la valeur de détection de courant, puis établit une valeur obtenue en additionnant une valeur absolue ou une valeur de carré pendant une certaine période de temps en tant que valeur d'indice.

4. Dispositif de conversion de puissance électrique selon la revendication 1, dans lequel le dispositif de conversion de puissance électrique a une fonction de détermination d'un critère de détermination si oui ou non la valeur d'indice calculée dépasse ou tombe en dessous d'une valeur de seuil prédéfinie pour détecter une détérioration d'isolation en utilisant la valeur d'indice calculée pendant une période d'apprentissage.

5. Dispositif de conversion de puissance électrique selon la revendication 1, dans lequel le dispositif de conversion de puissance électrique a une fonction de désignation d'une condition pour démarrer le calcul de la valeur d'indice.

6. Dispositif de conversion de puissance électrique selon la revendication 1, dans lequel le dispositif de conversion de puissance électrique a une fonction de sortie de la valeur d'indice calculée conjointement avec un paramètre qui définit un état de fonctionnement.

7. Dispositif de conversion de puissance électrique selon la revendication 1, dans lequel le signal de porteuse est une onde triangulaire.

8. Dispositif de conversion de puissance électrique selon la revendication 1, dans lequel le signal de porteuse est une onde triangulaire asymétrique dans laquelle une longueur d'une période d'augmentation d'une valeur minimale à une valeur maximale est différente d'une longueur d'une période de diminution d'une valeur maximale à une valeur minimale.

9. Dispositif de conversion de puissance électrique selon la revendication 1, comprenant en outre
une interface utilisateur pour commander un démarrage de diagnostic.

10. Dispositif de conversion de puissance électrique selon la revendication 1, comprenant en outre
une interface pour afficher une disponibilité de diagnostic, un état de progression de diagnostic, ou un résultat de diagnostic ou communiquer avec un extérieur.

11. Dispositif de conversion de puissance électrique selon la revendication 1, dans lequel le dispositif de conversion de puissance électrique alimente et reçoit une puissance électrique triphasée.

12. Dispositif de conversion de puissance électrique selon la revendication 1, dans lequel l'unité de diagnostic (41) est fixée extérieurement au dispositif de conversion de puissance électrique.

13. Système comprenant :
le dispositif de conversion de puissance électrique selon l'une quelconque des revendications 1 à 12 ; et
une machine rotative (20) ou un transformateur (30) connecté au dispositif de conversion de puissance électrique pour alimenter et recevoir une puissance électrique.

14. Procédé de diagnostic pour un système qui inclut un dispositif de conversion de puissance électrique incluant un circuit inverseur, et une unité de génération de signal PWM (141) qui compare un signal de porteuse avec une valeur de commande de tension et génère un signal PWM pour commander le circuit inverseur, et une machine rotative (20) ou un transformateur (30) ayant un fil d'enroulement connecté au dispositif de conversion de puissance électrique pour alimenter et recevoir une puissance électrique, le procédé comprenant :
une étape d'obtention d'une valeur de détection de courant en détectant un courant à partir d'un capteur de courant (16) qui détecte un courant alimenté à et reçu de la machine rotative (20) ou du transformateur (30) à un moment de détection qui est un moment d'un pic ou d'un creux du signal de porteuse ou à la fois du pic et du creux ;
une étape d'extraction de la valeur de détection de courant au moment de détection du courant en tant que valeur de détection de courant pour un diagnostic d'isolation lorsque le moment de détection est dans une certaine période de temps à partir d'un moment où la valeur de commande de tension et le signal de porteuse se croisent ;
une étape de calcul d'une valeur d'indice utilisée pour un diagnostic à partir de la valeur de détection de courant extraite ; et
une étape de détection d'une détérioration d'isolation du fil d'enroulement de la machine rotative (20) ou du transformateur (30) par un changement à partir d'un état normal de la valeur d'indice calculée.

15. Procédé de diagnostic selon la revendication 14, dans lequel l'étape de détection de la détérioration d'isolation inclut la détection d'un changement de capacité du fil d'enroulement.
